Europäisches Patentamt

European Patent Office

Office européen des brevets

(19)

(11) Veröffentlichungsnummer: **0 167 031**
**A2**

## (12) EUROPÄISCHE PATENTANMELDUNG

(21) Anmeldenummer: 85107242.1

(22) Anmeldetag: 12.06.85

(51) Int. Cl.⁴: **H 05 K 11/00**
**H 05 K 5/00**

(30) Priorität: 05.07.84 DE 3424689

(43) Veröffentlichungstag der Anmeldung:
08.01.86 Patentblatt 86/2

(84) Benannte Vertragsstaaten:
AT BE CH DE FR GB IT LI NL SE

(71) Anmelder: Elektra GmbH & Co. KG
Werkstrasse 7
D-4904 Enger(DE)

(72) Erfinder: Halemeier, Eckhard
Bakusbrink 35
D-4901 Hiddenhausen(DE)

(74) Vertreter: Patentanwälte Dipl.-Ing. Bodo Thielking
Dipl.-Ing. Otto Elbertzhagen
Gadderbaumer Strasse 20
D-4800 Bielefeld 1(DE)

(54) Gehäuse für eine elektronische Sende- und/oder Empfangseinrichtung.

(57) Ein Gehäuse für eine elektronische Sende- und/oder Empfangseinrichtung mit zwei elektrischen Zuleitungen (4; 5) besitzt einen Sockel (1) zum formschlüssigen Eingriff in eine stromführende Fassung. Die elektrischen Kontaktflächen (3; 3a) dieser Fassung sind mit den beiden Zuleitungen verbunden. Bei Ausbildung des Sockels (1) als Lampensockel kann das Gehäuse (2) in eine normale Glühlampenfassung eingesetzt werden. Bei Ausbildung des Sockels als Stromschienenadapter ist ein unmittelbarer mechanischer und elektrischer Anschluß an das zugehörige Stromschienensystem möglich.

FIG.1

EP 0 167 031 A2

Croydon Printing Company Ltd

0167031

Gehäuse für eine elektronische Sende- und/oder
Empfangseinrichtung

Die Erfindung betrifft ein Gehäuse für eine
elektronische Sende- und/oder Empfangseinrichtung,
die zwei elektrische Zuleitungen aufweist.

Bekannte Gehäuse dieser Art werden über Anschlußkabel mit den Stromquellen verbunden. So ist es
beispielsweise bekannt, zur Verbindung zwischen
einem Verstärker und einem Lautsprecher die ortsfest verlegten Elektrokabel zu verwenden. In diesem
Fall werden die Signale an einer Stelle in eine
Steckdose eingespeist und an einer anderen Stelle,
gegebenenfalls in einem anderen Raum der Lautsprecher mittels eines Stromkabels und verschiedener Übertragungsglieder mit einer anderen
Steckdose verbunden. Bei den bekannten Lösungen
dieser Art müssen die Lautsprecher in üblicher Weise
entweder an der Wand befestigt oder auf den Boden
gestellt werden.

Ausgehend von diesem Stand der Technik liegt der
Erfindung die Aufgabe zugrunde, ein Gehäuse der

- 2

- 2 -

eingangs erwähnten Art so auszubilden, daß es nicht nur elektrisch sondern auch mechanisch mit dem stromführenden System verbunden werden kann, so daß eine besondere Halterung für das Gehäuse entfällt.

Die Lösung dieser Aufgabe erfolgt erfindungsgemäß dadurch, daß das Gehäuse einen zum formschlüssigen Eingriff in eine stromführende Fassung ausgebildeten Sockel aufweist, dessen elektrische Kontaktflächen mit den beiden Zuleitungen verbunden sind.

Bei einer ersten bevorzugten Ausführungsform ist der Sockel ein Lampensockel.

Bei einer weiteren bevorzugten Ausführungsform ist der Sockel ein Stromschienenadapter.

Das Vorsehen eines am Gehäuse angeordneten Sockels erlaubt es, vorhandene Fassungen und Stromschienensysteme nicht nur zur Abnahme der Signale sondern auch zur mechanischen Halterung eines Gehäuses für unterschiedliche Einbauten zu verwenden. Bei der Ausbildung des Sockels als Lampensockel kann dieser in eine vorhandene Lampenfassung eingesetzt werden. Bei einer Ausbildung als Stromschienenadapter kann das Gehäuse unmittelbar an der Strom- schiene befestigt werden.

- 3 -

- 3 -

Das erfindungsgemäße System ist mit besonders großem Vorteil bei Stromschienensystemen verwendbar, die vor allen Dingen in gewerblichen Objekten umfangreich angewendet werden. Diese Stromschienensysteme werden bisher lediglich zur Übertragung des Beleuchtungsstroms verwendet. Das Vorsehen eines Gehäuses mit einem Sockel erlaubt es, in dieses Gehäuse jede Art von elektronischer Sende- und/oder Empfangseinrichtung einzusetzen und damit das Stromschienensystem universell für Zwecke zu verwenden, für die bisher eine separate Verdrahtung erforderlich war. So ist es beispielsweise möglich, das Gehäuse mit einem Lautsprecher zu bestücken und über das Stromschienensystem Musik oder Informationen zu verteilen. Ebenso kann statt des Lautsprechers ein Mikrofon im Gehäuse angeordnet sein, welches Geräusche und Informationen von dem jeweiligen Einsatzort übernimmt und an eine andere Stelle transportiert. Es können die Bauteile von Gegensprechanlagen eingesetzt werden. Ebenso ist es möglich, in das Gehäuse Rauch- oder Feuermelder einzusetzen, die bisher an ein eigenes Installationssystem angeschlossen werden mußten. Ebenso können auf diese Weise Bewegungsmelder an beliebigen Stellen des Stromschienensystems angeordnet werden, so daß sich die stromführenden Leiter des Stromschienensystems oder der vorhandenen Installation als Informationsträger für Einbruchsicherungsanlagen verwenden lassen.

- 4 -

- 4 -

Es hat sich als besonders zweckmäßig erwiesen, daß das Gehäuse rotationssymmetrisch ausgebildet ist. Wenn es dabei gemäß einem weiteren Vorschlag der Erfindung die Form einer Glühlampe aufweist, kann es besonders einfach in vorhandene Lampenfassungen eingesetzt werden.

Nachstehend wird eine bevorzugte Ausführungsform der Erfindung anhand der Zeichnung im einzelnen beschrieben. Es zeigen:

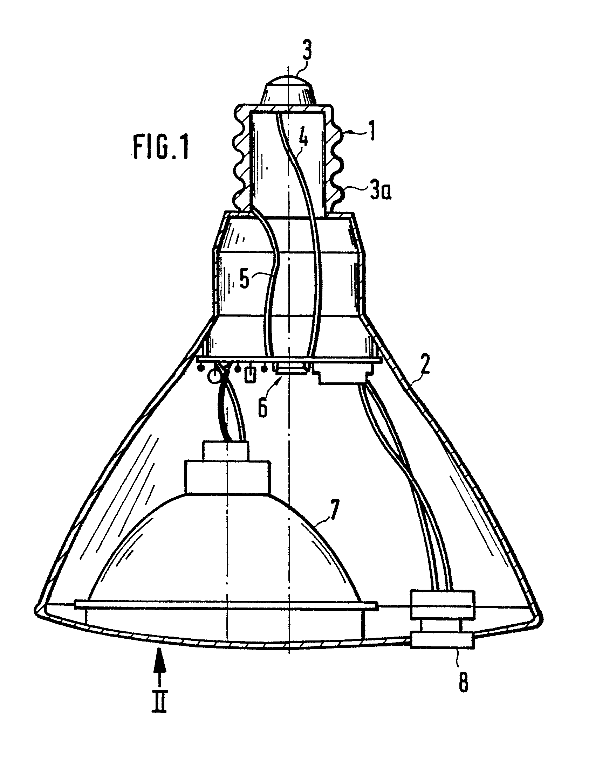

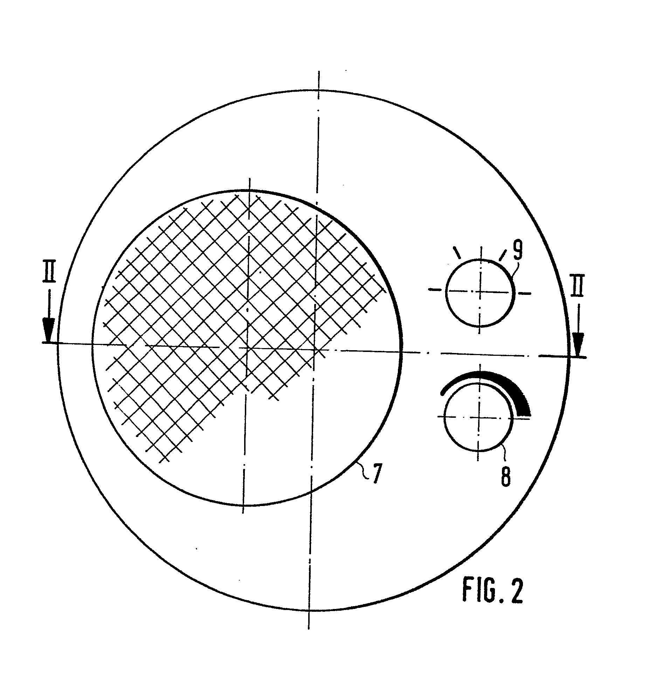

Figur 1 - einen Längsschnitt entlang Ebene II-II in Figur 2 durch ein Gehäuse in Form einer Glühlampe,

Figur 2 - eine Ansicht in Richtung des Pfeils II in Figur 1 auf das Gehäuse.

Im dargestellten Ausführungsbeispiel hat das Gehäuse 2 die Form einer PAR-Glühlampe. Der Sockel 1 ist als Schraubsockel ausgebildet. Er besitzt einen Mittenkontakt 3 und das Schraubgewinde 3a. Der Mittenkontakt 3 ist über die Zuleitung 4 mit der elektrischen Leiterplatte 6 verbunden. Das Schraubgewinde 3a, welches die zweite elektrische Kontaktfläche darstellt, ist über die Zuleitung 5 mit der Leiterplatte 6 verbunden. Auf der Leiterplatte sind elektronische Bauteile angedeutet. Die Leiterplatte ist über Zuleitungen mit einem Lautsprecher 7 und einem Lautstärkeregler 8 verbunden. Mit 9 ist ein Kanalwähler bezeichnet.

0167031

Patentansprüche:

1. Gehäuse für eine elektronische Sende- und/oder Empfangseinrichtung, die zwei elektrische Zuleitungen aufweist, dadurch gekennzeichnet, daß es einen zum formschlüssigen Eingriff in eine stromführende Fassung ausgebildeten Sockel (1) aufweist, dessen elektrische Kontaktflächen (3; 3a) mit den beiden Zuleitungen (4; 5) verbunden sind.

2. Gehäuse nach Anspruch 1, dadurch gekennzeichnet, daß der Sockel (1) ein Lampensockel ist.

3. Gehäuse nach Anspruch 1, dadurch gekennzeichnet, daß der Sockel ein Stromschienenadapter ist.

4. Gehäuse nach einem oder mehreren der Ansprüche 1 bis 3, dadurch gekennzeichnet, daß es rotationssymmetrisch ausgebildet ist.

5. Gehäuse nach Anspruch 4, dadurch gekennzeichnet, daß es die Form einer Glühlampe aufweist.

1/2

FIG.1

0167031

FIG. 2